# DEMANDE DE BREVET EUROPEEN

(11) **EP 1 739 601 A1**
(43) Date de publication de la demande: **03.01.2007**
(21) Numéro de dépôt: 05291372.0
(22) Date de dépôt: 24.06.2005
(51) Int. Cl.: G06K 19/08, G06K 19/04

(54) **Dispositif portable comprenant deux cavités pour deux supports de données utilisables dans deux lecteurs differents, et methode pour le fabriquer**

(71) Demandeur: Axalto SA, 92120 Montrouge (FR)
(72) Inventeur: Berkovich, Leonid AXALTO SA, 92120 Montrouge (FR); El Yamani, Hayat AXALTO SA, 92120 Montrouge (FR); Muscetta, Raffaele AXALTO SA, 92120 Montrouge (FR); Quan, San Yut AXALTO SA, 92120 Montrouge (FR)
(74) Mandataire: Cour, Pierre

(57) **Abrégé**

L'invention propose une nouvelle méthode de fabrication d'une carte à puce incluant un disque optique 4. Selon l'invention le disque 4 est fabriqué séparément puis assemblé dans une carte réalisée en deux couche1 et 2. La carte ainsi réalisée comporte une première cavité 11 pour recevoir un module 3 et une deuxième cavité pour recevoir le disque 4. La deuxième cavité est définie par un trou circulaire 12 situé dans la couche 1 et est partiellement obturée par la couche 2.

## Description

L'invention se rapporte à un dispositif portable pour supporter des données. En particulier, l'invention se rapporte à un dispositif comprenant deux supports de données lisibles dans deux types de lecteurs différents.

WO 2004/006179 dévoile un dispositif portable sécable qui comporte un support de données de type optique et un circuit intégré. Ce dispositif est réalisé comme un disque optique de type CD en polycarbonate selon une technique connue qui est ensuite usiné pour, d'une part, réaliser une cavité destinée à recevoir un module de carte à puce, et, d'autre part, lui donner la forme d'une carte à puce comportant au moins une ligne de rupture. La carte ainsi formée, comporte un disque optique de forme carré ou rectangulaire après séparation selon la ligne de rupture et une puce utilisable comme carte selon un format carte SIM.

Par ailleurs, il est également connu de mouler des cartes en polycarbonate transparent et comprenant au moins deux zones séparées par une ligne de rupture. Une cavité est moulée dans l'une des zones pour recevoir un module, et un trou de centrage est moulé dans une autre zone qui constitue un disque optique. Un disque de matériau réfléchissant est ensuite collé de manière centrée autour du trou de centrage et une étiquette de protection est collée sur l'ensemble.

Ces deux techniques permettent d'obtenir une carte à puce au format SIM dont une partie séparable se transforme en disque optique. De plus, Après séparation, si des lignes de ruptures adéquates ont été prévues, il est possible de pouvoir utiliser la puce dans un format de carte SIM. Un inconvénient de ces techniques est qu'il est nécessaire d'usiner ou de mouler du polycarbonate. Or le moulage et l'usinage du polycarbonate sont relativement coûteux pour des formes aussi complexe. Egalement, le placement de module dans une carte en polycarbonate s'avère coûteux et difficile à maîtriser pour de la production de masse. Enfin, l'état de la technique réalise des cartes combinées avec des disques optiques de type CD dont l'épaisseur de 1,2 mm n'est pas compatible avec le format ISO 7816 d'une carte à puce dont l'épaisseur est limitée à 0,8 mm.

L'invention propose une nouvelle méthode de fabrication d'une carte à puce incluant un disque optique. Selon l'invention le disque est fabriqué séparément puis assemblé dans une carte réalisée dans des matériaux plus traditionnels pour la fabrication de carte et donc moins coûteux et plus facile à mettre en oeuvre.

Selon un premier aspect, l'invention est un dispositif portable à deux cavités qui comporte une première couche et une deuxième couche. La première couche, réalisée dans un premier matériau, a une première épaisseur. Ladite première couche comporte une première cavité destinée à recevoir un module et un premier trou circulaire. La deuxième couche, réalisée dans un deuxième matériau, a une deuxième épaisseur et l'une de ses faces est collée sur une face de la première couche. La deuxième couche comporte un deuxième trou circulaire de diamètre inférieur au premier trou circulaire et centré sur le même axe. Après collage des première et deuxième couches, le premier trou circulaire forme une deuxième cavité destinée à recevoir un disque optique.

Selon un deuxième aspect, l'invention est un dispositif portable qui comporte une première couche, une deuxième couche, un module et un disque optique. La première couche, réalisée dans un premier matériau, a une première épaisseur. Ladite première couche comporte une première cavité et un premier trou circulaire. La deuxième couche, réalisée dans un deuxième matériau, a une deuxième épaisseur et l'une de ses faces est collée sur une face de la première couche. La deuxième couche comporte un deuxième trou circulaire de diamètre inférieur au premier trou circulaire et centré sur le même axe. Le module inclut un circuit intégré. Ledit module est placé dans la première cavité et collé à la première couche. Le disque optique a un diamètre externe qui correspond au diamètre du premier trou circulaire. Une face du disque optique est collée à la deuxième couche dans une deuxième cavité définie par le premier trou circulaire et la deuxième couche.

Préférentiellement, le dispositif peut comporter au moins une ligne de rupture placée entre la première cavité et la deuxième cavité. La première cavité de la première couche peut être ouverte sur la face en contact avec la deuxième couche, et la deuxième couche peut comporter une ouverture traversée par le module.

Selon un troisième mode de réalisation, l'invention est un procédé de fabrication d'un dispositif portable à deux cavités. Ledit procédé comporte les étapes de fabrication d'une première et d'une deuxième couches, de positionnement et de collage des première et deuxième couches. La fabrication de la première couche à l'aide d'un premier matériau est réalisée pour avoir une première épaisseur, ladite première couche comportant une première cavité et un premier trou circulaire. La fabrication de la deuxième couche à l'aide d'un deuxième matériau est réalisée pour avoir une deuxième épaisseur, la deuxième couche comportant un deuxième trou circulaire de diamètre inférieur au premier trou circulaire et centré sur le même axe. Le positionnement et le collage de la première couche sur la deuxième couche, se fait de sorte que le premier trou circulaire fermé au moins partiellement par la deuxième couche forme une deuxième cavité.

En outre le procédé peut comporter des étapes de fabrication d'un module, de fabrication d'un disque, de positionnement du disque et du module. La fabrication du module inclut un circuit intégré. La fabrication du disque optique se fait préférentiellement pour obtenir un disque dont l'épaisseur est égale à la première épaisseur et dont le diamètre externe correspond au diamètre du premier trou circulaire. Le positionnement du disque se fait dans la deuxième cavité et le collage du disque se fait sur la deuxième couche. Le positionnement du module se fait dans la première cavité et le collage du module se fait sur la première couche.

Préférentiellement, la fabrication de la première couche peut se faire par moulage. Au cours de la fabrication de la deuxième couche, on peut réaliser une ouverture destinée à être en regard de la première cavité de la première couche. On peut réaliser un pré-découpage du dispositif afin de réaliser au moins une ligne de rupture permettant la séparation de la partie comportant le module de la partie comportant le disque, ladite étape de pré-découpage pouvant être réalisée par découpe au laser.

L'invention sera mieux comprise, et d'autres particularités et avantages apparaîtront à la lecture de la description qui va suivre, la description faisant référence aux dessins annexés, parmi lesquels :
la figure 1 représente un premier exemple de dispositif selon l'invention en vue éclaté.
la figure 2 représente le dispositif de la figure 1 en coupe transversale,
la figure 3 représente une variante d'un dispositif selon l'invention en coupe transversale, et
la figure 4 représente une vue de face du dispositif de la figure 3.

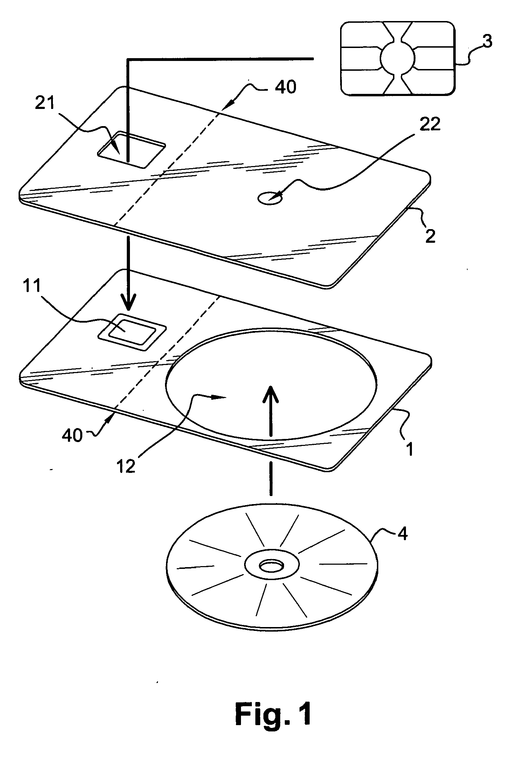

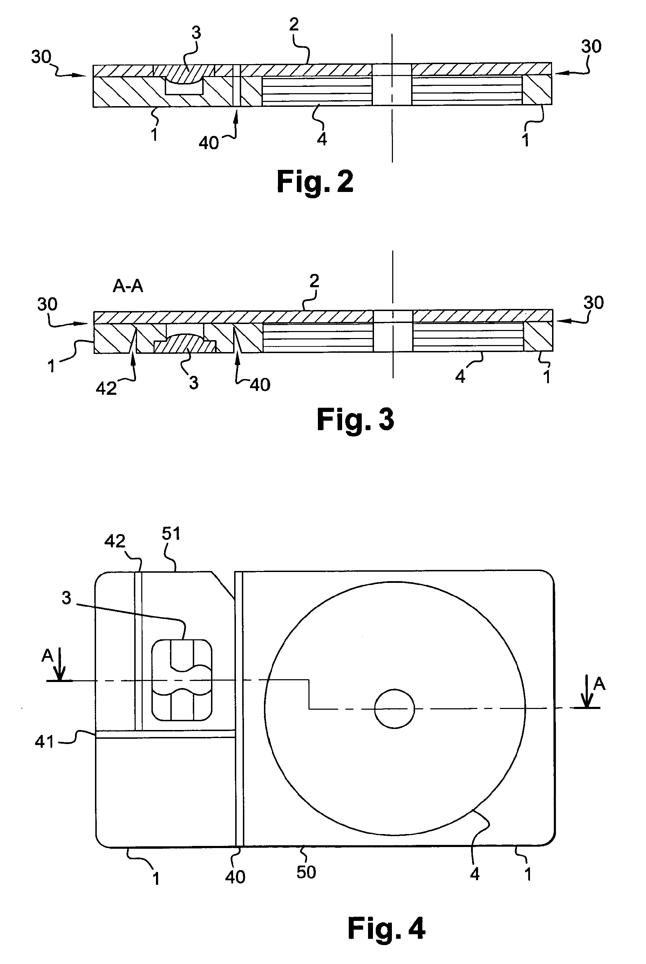

La figure 1 montre un premier mode de réalisation d'un dispositif portable selon l'invention en vue éclatée. La figure 2 montre le même dispositif selon un plan de coupe transversal permettant de voir la constitution du dispositif assemblé. Les mêmes références sont utilisées pour les mêmes éléments. Pour mieux visualiser certains détails, les dessins ne sont pas réalisés à l'échelle.

Préférentiellement le dispositif portable est une carte à puce au format ISO. Le dispositif portable comporte une première couche 1, une deuxième couche 2, un module 3 et un disque optique 4. Les première et deuxième couches 2 et 3 peuvent être réalisée de différentes manières par usinage ou par moulage en utilisant différents matériaux, tels que par exemple le PVC ou l'ABS. Le disque optique 4 est réalisé en polycarbonate mais sa forme circulaire permet d'utiliser un procédé de fabrication connu pour la réalisation de disque optique. Le module 3 est un module connu de carte à puce, réalisé selon une technique connue.

Selon un procédé de fabrication préféré, un moulage par injection d'ABS dans un moule approprié est réalisé pour obtenir la première couche 1. Le moulage permet d'obtenir la première couche 1, par exemple aux dimensions d'une carte de type ISO ayant une longueur de 85,6 mm et une largeur de 54 mm. La couche est munie, lors du moulage, d'une part, d'une cavité 11, et, d'autre part, d'un trou circulaire 12. La cavité 11 est destinée à recevoir le module 3. Le trou circulaire est destiné à recevoir le disque 5. Le moulage par injection permet d'obtenir une grande précision sur la taille du trou circulaire 12 pour pouvoir correspondre le plus justement à la taille du disque 4. A titre d'exemple le diamètre du trou circulaire 12 et du disque 4 est de 53 mm pour une largeur de carte de 54 mm.

Préférentiellement le disque optique 4 et la première couche 1 ont une même épaisseur, par exemple 600 *µ*m. Une telle épaisseur permet d'utiliser un disque optique de type DVD. L'utilisation d'un disque DVD permet d'obtenir au final une carte compatible avec le format carte ISO 7816. Un disque au format CD pourrait être utilisé mais se trouve être plus épais, donc non compatible avec le format ISO et permet de stocker moins de données qu'un DVD de même diamètre.

La deuxième couche 2 est une couche plus fine qui est par exemple en ABS ou en PVC. Dans un procédé de fabrication préféré, elle est réalisée par usinage, en utilisant par exemple un procédé de découpe par emboutissage. Préalablement à la découpe, il est possible d'imprimer cette couche en utilisant une technique d'impression connue. La découpe de la deuxième couche 2 permet de découper ladite couche au format ISO, et de réaliser une ouverture 21 et un trou circulaire 22. L'ouverture 21 est située en regard de la cavité 11 de la première couche 1 et le trou circulaire 22 et coaxial au trou circulaire 12 de la première couche 1 lorsque les deux couches sont assemblées. L'ouverture 21 est de la forme et de la taille du connecteur du module 3. Le trou circulaire 22 est de la même taille que le trou situé dans le disque 4 pour l'entraîner en rotation dans un lecteur de disque. L'épaisseur de la deuxième couche 2 est inférieure à 200 *µ*m afin que l'ajout d'une couche de colle entre la première et deuxième couche pour l'assemblage des première et deuxième couche permettent d'obtenir une épaisseur d'environ 800 µm après collage.

L'assemblage de la carte en réalisant un dépôt d'une couche de colle 30 sur une face de la deuxième couche 2 puis en appliquant la face encollée sur la première couche 1 et le disque 4, le disque 4 étant positionné dans le trou circulaire 12 qui forme également une cavité. L'ensemble est pressé le temps nécessaire à la solidification de la colle. Un dépôt de colle est ensuite effectué dans la cavité 11 et enfin le module 3 est placé dans la cavité 11 selon une technique conventionnelle et maîtrisée.

L'ensemble ainsi obtenu est une carte à puce au format ISO qui dispose en outre d'un disque optique de type DVD. Cependant, le disque DVD n'est pas centré par rapport à la carte et l'utilisation de la carte ainsi formée dans un lecteur de disque est source de vibration. Pour remédier à ces vibrations, il est prévu de pouvoir séparer le module du disque. Pour réaliser la séparation entre la puce et le disque, une ligne de rupture 40 est formée sur la carte. La ligne de rupture est par exemple réalisée après l'assemblage de la carte en effectuant une pré-découpe en pointillés de la carte à l'aide d'un laser.

Ainsi, la carte peut être utilisée comme une carte à puce au format ISO tant que le disque n'est pas séparé. Puis pour pouvoir utiliser le disque de manière optimum, un utilisateur peut casser la carte et obtenir un support de disque équilibré pour l'utiliser dans un lecteur de disque.

Les figures 3 et 4 montrent une variante de réalisation dans laquelle, la carte à puce au format ISO se sépare d'une partie rectangulaire 50 qui se comporte en un disque équilibré, et d'autre part en un plug 51, par exemple, au format carte SIM de longueur 25 mm et de largeur 15 mm. Cet exemple comporte trois lignes de rupture 40, 41 et 42 qui sont ici réalisées lors du moulage de la première couche 1. Les lignes de rupture correspondant à des gorges biseautées fragilisant la carte, les lignes de rupture 40, 41 et 42 étant d'épaisseur inférieure à l'épaisseur de la première couche.

Dans cette variante, le module 3 est collé du même coté que le disque 4. Il n'est alors plus nécessaire de réaliser une ouverture dans la deuxième couche 2 en regard de la cavité 11. En outre la cavité 11 peut être traversante car la deuxième couche 2 assure la fermeture de ladite cavité. L'assemblage de cette carte se fait comme précédemment indiquer.

## Revendications

1. Dispositif portable à deux cavités **caractérisé en ce qu'**il comporte :
- une première couche (1) d'un premier matériau ayant une première épaisseur, ladite première couche comportant une première cavité (11) destinée à recevoir un module (3) et un premier trou circulaire (12),
- une deuxième couche (2) d'un deuxième matériau ayant une deuxième épaisseur et dont une face est collée sur une face de la première couche (1), la deuxième couche (2) comportant un deuxième trou circulaire (22) de diamètre inférieur au premier trou circulaire (12) et centré sur le même axe,
et dans lequel, après collage des première et deuxième couches (1 et 2), le premier trou circulaire forme une deuxième cavité destinée à recevoir un disque optique (4).

2. Dispositif portable **caractérisé en ce qu'**il comporte:
- une première couche (1) d'un premier matériau ayant une première épaisseur, ladite première couche comportant une première cavité (11) et un premier trou circulaire (12),
- une deuxième couche (2) d'un deuxième matériau ayant une deuxième épaisseur et dont une face est collée sur une face de la première couche (1), la deuxième couche (2) comportant un deuxième trou circulaire (22) de diamètre inférieur au premier trou circulaire (12) et centré sur le même axe,
- un module (3) incluant un circuit intégré, ledit module (3) étant placé dans la première cavité (11) et collé à la première couche (1),
- un disque optique (4) dont le diamètre externe correspond au diamètre du premier trou circulaire (12), une face du disque optique étant collée à la deuxième couche (2) dans une deuxième cavité définie par le premier trou circulaire et la deuxième couche.

3. Dispositif portable selon la revendication 1 ou 2, dans lequel la première couche (1) dispose en outre d'au moins une ligne de rupture (40-42) placée entre la première cavité (11) et la deuxième cavité, ladite ligne étant d'une épaisseur inférieure à la première épaisseur.

4. Dispositif portable selon la revendication 1 ou 2, lequel comporte au moins une ligne de rupture (40) placée entre la première cavité (11) et la deuxième cavité, ladite ligne de rupture étant réalisée par une pré-découpe du dispositif.

5. Dispositif portable selon l'une des revendications 1 à 4, dans lequel la première cavité (11) de la première couche (1) est ouverte sur la face en contact avec la deuxième couche (2), et dans lequel la deuxième couche (2) comporte une ouverture (21) traversée par le module.

6. Dispositif portable selon l'une des revendications 1 à 5, ledit dispositif formant une carte à puce au format ISO.

7. Dispositif portable selon la revendication 3 ou 4, dans lequel, après rupture dudit dispositif, la partie (51) contenant le module (3) forme une carte à puce au format carte SIM.

8. Dispositif selon l'une des revendications 1 à 7, dans lequel le disque optique (4) est un DVD dont l'épaisseur est égale à l'épaisseur de la première couche.

9. Procédé de fabrication d'un dispositif portable à deux cavités, ledit procédé comportant les étapes de :
- fabrication d'une première couche (1) d'un premier matériau ayant une première épaisseur, ladite première couche comportant une première cavité (11) et un premier trou circulaire (12),
- fabrication d'une deuxième couche (2) d'un deuxième matériau ayant une deuxième épaisseur, la deuxième couche comportant un deuxième trou circulaire (22) de diamètre inférieur au premier trou circulaire et centré sur le même axe,
- positionnement et collage de la première couche (1) sur la deuxième couche (2) de sorte que le premier trou circulaire fermé au moins partiellement par la deuxième couche forme une deuxième cavité.

10. Procédé selon la revendication 9, **caractérisé en ce qu'**il comporte en outre les étapes de :
- fabrication d'un module (3) incluant un circuit intégré,
- fabrication d'un disque optique (4) dont l'épaisseur est égale à la première épaisseur et dont le diamètre externe correspond au diamètre du premier trou circulaire (12),
- positionnement du disque (4) dans la deuxième cavité et collage du disque (4) sur la deuxième couche (2),
- positionnement du module (3) dans la première cavité (11) et collage du module (3) sur la première couche (1).

11. Procédé selon la revendication 9 ou 10, dans lequel la fabrication de la première couche (1) se fait par moulage.

12. Procédé selon l'une des revendications 9 à 11, dans lequel, au cours de la fabrication de la deuxième couche (2), on réalise une ouverture (21) destinée à être en regard de la première cavité (11) de la première couche (1).

13. Procédé selon l'une des revendications 9 à 12, dans lequel on effectue, après collage, une étape de pré-découpage du dispositif afin de réaliser au moins une ligne de rupture (40) permettant la séparation de la partie comportant la première cavité de la partie comportant la deuxième cavité, ladite étape de pré-découpage étant réalisée par découpe au laser.
